(19) Europäisches Patentamt
European Patent Office
Office européen des brevets

(11) Publication number: 0 174 743 A2

# (12) EUROPEAN PATENT APPLICATION

(21) Application number: 85305747.9

(51) Int. Cl.[4]: C23C 16/34 , //H01L29/40

(22) Date of filing: 13.08.85

(30) Priority: 05.09.84 US 648115

(43) Date of publication of application: 19.03.86 Bulletin 86/12

(84) Designated Contracting States: AT BE CH DE FR GB IT LI NL SE

(71) Applicant: MORTON THIOKOL, INC.
110 North Wacker Drive
Chicago Illinois 60606(US)

(72) Inventor: Melas, Andreas A.
2 Pine Avenue
Burlington Maryland 01803(US)

(74) Representative: Bankes, Stephen C. D. et al
Baron & Warren 18 South End Kensington
London W8 5BU(GB)

## (54) Process for transition metal nitrides thin film deposition.

(57) Chemical vapour deposition process for depositing a transition metal nitride coating on a substrate. The coating has utility as a conductor in a microelectronic device. The transition metal source material for the process is a transition metal azide or aliphatic amine, optionally halogenated, which is a liquid at bubbler temperature. The compound is transported to a deposition chamber containing a substrate; in one embodiment transport is effected by a carrier gas comprising a mixture of hydrogen with hydrazine vapour or nitrogen. The deposition chamber containing the substrate is maintained under pyrolytic conditions to decompose the transition metal compound source material and to form a transition metal nitride on the substrate.

EP 0 174 743 A2

# PROCESS FOR TRANSITION METAL NITRIDE THIN FILM DEPOSITION

This invention relates to materials, apparatus, and processes for chemical vapor deposition (CVD) of thin films of transition metal nitrides on suitable substrates. Transition metal nitride coatings are very good conductors of electricity and are relatively inert to oxidation and other reactions compared to the pure metals from which they are derived. Such coatings are used as conductors in microelectronic devices.

Previously, transition metal nitride films have been deposited on suitable substrates by sputtering the constituent metal in an ammonia or nitrogen atmosphere. A nitrogen atmosphere has been particularly preferred when evaporating the chosen metal from a target by electron beam evaporation. When a film is deposited by sputtering, it is hard to control the evenness and thickness of the film, particularly when the sputtering operation is conducted under a nitrogen atmosphere. Many transition metals are also refractory and thus difficult to sputter or evaporate. To illustrate this problem, the melting points and boiling points of certain transition metals are set forth in Table I immediately below:

TABLE I

| Element | Boiling Point | Melting Point |
|---|---|---|
| Tungsten | 5927°C | 3410°C |
| Molybdenum | 5560°C | 2610°C |
| Tantalum | 5400°C | 2996°C |
| Hafnium | 5400°C | 2150°C |
| Niobium | 4927°C | 2468°C |
| Zirconium | 3578°C | 1852°C |
| Titanium | 3260°C | 1675°C |
| Vanadium | 3000°C | 1890°C |
| Chromium | 2482°C | 1890°C |

A microelectronic device, such as a large scale or a very large scale integrated circuit, is sensitive to high temperatures, particularly temperatures exceeding 800°C. It is difficult or impossible to sputter a transition metal nitride coating or pattern on such a device without damaging the previously formed portions of the device. Thus, a problem in the art has been how to successfully deposit transition metal nitride coatings at the moderate temperatures and other conditions necessary for fabrication of microelectronic devices.

CVD is a process whereby a normally liquid or gaseous compound of a metal desired to be deposited is delivered to a heated or electromagnetically energized deposition chamber containing a substrate to receive the deposit. The thermal or electromagnetic energy in the deposition chamber causes the compound to decompose, freeing the constituent metal for direct deposition on the substrate, or for further reaction with other materials in the deposition chamber, followed by deposition of the reaction product. A special advantage of CVD is realized when an organometallic compound or other compound of the desired transition metal has a much higher vapor pressure at moderate temperatures than the corresponding metal, and decomposes to release the corresponding metal or form compounds thereof at the 400°C to 800°C deposition temperatures which should not be exceeded during electronic device fabrication.

Typical apparatus currently in use for CVD comprises a bubbler which contains a supply of the transition metal compound chosen for a particular process, a reactor or deposition chamber which contains the substrate on which a film is to be deposited, a source of a carrier gas which is inert to the transition metal compound in the bubbler and either inert or reactive to the compound in the deposition chamber, and optionally sources of other reactants supplied to the reaction chamber. The bubbler and contents are maintained at a constant and relatively low temperature which typically is above the melting point of the transition metal compound but below its decomposition temperature. Bubblers are usually maintained at a controlled temperature between the extremities of about -20°C and 60°C. To operate the CVD apparatus, the carrier gas is introduced into the bubbler under the surface of the liquid transition metal compound. Rising bubbles of the carrier gas provide a large, constant contact surface and thus uniformly vaporize the compound. The carrier gas and vapor collected in the headspace of the bubbler are continuously directed to the deposition chamber.

Certain of the liquid transition metal compounds disclosed herein are known, and some have been suggested for use in CVD, but the inventor is not aware that the processes disclosed herein have previously been used for depositing transition metal nitride films.

The inventor has discovered a process for depositing a coating of a selected transition metal nitride on a substrate. First, the chosen substrate is placed within a deposition chamber. Next, a compound of the chosen transition metal is selected, having the formula:

$$MR_x$$

wherein M is the selected transition metal; each R is independently selected from the group consisting of halogen, azide, and

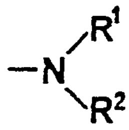

wherein $R^1$ and $R^2$ are selected from the group consisting of hydrogen, lower alkyl, cyclopentadienyl, and alkyl substituted cyclopentadienyl; at least one R is not halogen; and x is an integer between 2 and 6 inclusive representing the valence of M. The compound of the chosen transition metal is then introduced into the deposition chamber while maintaining pyrolytic, nitride forming conditions for said compound within the deposition chamber. Specific nitride forming conditions are set forth later in the specification. As a result of this process, a transition metal nitride film is formed on the substrate.

The transition metal compounds contemplated for use herein have the molecular formula and can include the substituents set forth previously in the Summary of the Invention section. The preferred compounds are liquids at some temperatures between -20°C and 60°C.

Specific transition metals M contemplated within the scope of the preceding formula are listed in Table I set forth in the Background Art section.

Halogens contemplated for use herein include Fluorine, Chlorine, Bromine and Iodine.

Lower alkyl is defined, for the purpose of applying the preceding formula, as a substituent having from one to four carbon atoms inclusive, and specifically includes methyl, ethyl, n-propyl, isopropyl, n-butyl, isobutyl, and t-butyl. Alkyl substituted cyclopentadienyl as defined herein includes alkyl substituted cyclopentadienyl and cyclopentadienyl substituted alkyl, alkyl being lower alkyl as exemplified above. Specific substituents contemplated within the meaning of alkylsubstituted cyclopentadienyl are as follows: methylcyclopentadienyl, 4-(cyclopentadienyl)-n-butyl, pentamethylcyclopentadienyl, and cyclopentadienyl substituted by up to six like or different lower alkyl groups are linked directly or by one of the lower alkyl groups to the Nitrogen atom of R. Specific R substituents contemplated herein include dimethylamino and diethylamino.

x represents the valence of M, and is an integer from two to six depending on the characteristic (and often multiple) valence of each metal.

Specific transition metal compounds contemplated for use herein include the following:

Tetrakis(diethylamino)titanium,

Tetrakis(dimethylamino)titanium;

Tetrakis(diethylamino)zirconium;

Tetrakis (dimethylamino)zirconium;

Titanium azide;

Tetrakis(dicyclopentadienylamino)zirconium;

Tetrakis[di(2-cyclopentadienylethyl)amino]-zirconium;

Tetraaminozirconium;

Hexakis(dimethylamino)tungsten;

Hexakis(dimethylamino)molybdenum;

Pentakis(diethylamino)tantalum;

Tetrakis(diethylamino)hafnium;

Pentakis(diethylamino)niobium;

Pentakis(diethylamino)vanadium;

Hexakis(diethylamino)chromium; and

Tris(diethylamino)monochlorotitanium.

The first three compounds in the above list are available from Alfa Products, a division of Morton Thiokol, Inc. located in Danvers, Massachusetts, 01923. The other compounds listed above may be synthesized as explained below.

Dialkylamino derivatives of transition metals are synthesized by reacting the corresponding dialkylamide of Lithium with a transition metal chloride in a solvent or solvent mixture having ether or aromatic functionality. Lithium chloride is precipitated and removed by filtration, leaving a dialkylamino-substituted compound of the transition metal. The reaction is summarized by the following chemical equation:

$$MCl_x + LiN(R^1R^2) \longrightarrow X\ LiCl + M[-N(R^1R^2)]_x$$

To provide the pure compound, the solvent is stripped and the product is distilled. Distillation can ordinarily proceed at moderate temperatures, since these compounds are liquids. An alternate method of synthesizing the amino-substituted transition metal compounds is to heat the corresponding amine with a halide of the corresponding transition metal, according to the following reaction:

$$MCl_x + X\ HN(R_1R_2) \longrightarrow X\ HCl + M[N(R_1R_2)]_x$$

The reaction is then worked up essentially as described above in the Lithium reaction. The halogenated, amino-substituted transition metal compounds disclosed herein can be synthesized according to this reaction by providing an excess of the transition metal halide.

To form a transition metal azides, the chloride of the appropriate transition metal is reacted with Sodium or Lithium azide to form the product, which is then worked up as described for the dialkylamino compounds. The equation for this reaction is as follows:

$$MCl_x + X\ NaN_3 \longrightarrow X\ NaCl + M(N_3)_x$$

Now the process conditions for conducting a metal organic chemical vapor deposition process utilizing the previously described compounds will be discussed.

It is possible to conduct the deposition process without a carrier gas, simply by allowing the transition metal compound used as a source of the transition metal to diffuse into the deposition chamber, or by drawing the transition metal compound vapor into the deposition chamber by means of a vacuum pump located at the outlet of the deposition chamber. But in the preferred practice of the present invention a carrier gas is used to entrain the transition metal compound and carry it into the deposition chamber. The preferred carrier gases will react with the selected transition metal under the pyrolytic conditions maintained in the deposition chamber to produce a transition metal nitride coating.

The carrier gas can be Hydrogen, Nitrogen or mixtures of those gases, the mixture being preferred over either component alone. A mixture of hydrazine gas and Hydrogen is also contemplated within the scope of the invention. The preferred Hydrogen/hydrazine mixtures contain from about 10% to about 20% hydrazine (by volume). The Hydrogen in the carrier gas is a reducing agent which prevents oxidation of the transition metal, while the Nitrogen in the carrier gas or derived from the substituents of the transition metal compound reacts with the transition metal compound in the deposition chamber to form a nitride. The flow rate of the carrier gas (providing one is used) can be as low as a few cubic centimeters per minute and as high as several liters per minute. The pressure of the carrier gas is commonly atmospheric pressure, although a lower pressure can be used if desired.

The chosen transition metal compound is evaporated in controlled fashion to enable its transportation into the deposition chamber as a vapor. Preferred apparatus is a bubbler in which the transition metal compound vapor is entrained on a carrier gas. The partial pressure of the transition metal compound in the carrier gas can be from about 0.2 torrs to about 100 torrs. The bubbler is maintained at a particular temperature which is high enough to provide a substantial vapor pressure for the liquid transition metal compound and low enough to avoid decomposition in the bubbler. Typical bubbler temperatures are from -20°C to 60°C, depending on the particular transition metal compound selected.

For ordinary CVD, the deposition chamber is maintained at a temperature of from about 400°C to about 800°C, preferably from about 650°C to 700°C. The higher the temperature of the deposition chamber, the faster the transition metal compound decomposes and reacts to form the transition metal nitride coating. If plasma-enhanced chemical vapor deposition is employed the deposition chamber is provided with an electromagnetic coil to generate a radio frequency field, forming a plasma of the species within the deposition chamber. The frequency of the field is typically 450 kHz. If a plasma enhanced deposition process is selected, the temperature of the deposition chamber can be from about 300°C to about 400°C. (The electromagnetic field encourages decomposition of the transition metal compound, allowing the substrate to be maintained at a lower temperature.) If a laser or photo-excited chemical vapor deposition is employed, the temperature of the deposition chamber can be less than 300°C.

Any known substrate can be used to receive a deposit of the transition metal nitride film. Well known substrates include crystalline Silicon and Gallium arsenide.

Regulation of the factors just described in a well known manner will regulate the rate of deposition of a transition metal nitride film on the substrate. Typical deposition rates range from 10 to 1000 angstroms per minute and a common deposition rate is 100 angstroms per minute. The final thickness of the film for typical microelectronic devices will be at least about one micron (10,000 angstroms), and a usual upper limit of thickness is several microns. Of course, thicker or thinner films than those described herein are also contemplated within the scope of the present invention.

## EXAMPLE 1

### Deposition of Titanium Nitride of a Silicon Substrate

In this example Titanium nitride is deposited on a crystalline Silicone substrate, using tetrakis(dimethylamino)titanium as a source meterial. The apparatus used is the same as set forth in the diagram in Marinace, "Thin Films of a Silicon-Carbon Compound",

IBM Technical Disclosure Bulletin, Volume 17, No. 10, (1975). That reference is hereby incorporated herein by reference. In this example, the carrier gas is a mixture of 50% Nitrogen and 50% hydrogen delivered at atmospheric pressure. The partial pressure of the Titanium compound is about 100 torrs. The flow rate of the carrier gas is about one liter per minute, and the bubbler is maintained at about 35°C. The deposition chamber is maintained at about 700°C. Under these conditions, a Titanium nitride coating is deposited on the substrate at a deposition rate of about 100 angstroms per minute. The deposition process is continued for about 100 minutes, resulting in a final film thickness of about 1 micron.

EXAMPLE 2

Deposition of Other Transition Metal Nitrides

The procedure of Example 1 is followed, except that in individual experiments each of the transition metal compounds previously identified is used in plate of tetrakis(dimethylamino) titanium to deposit the nitride of the respective transition metal on a crystalline Silicon substrate. The resulting films are found to be composed of substantially pure nitrides of the respective transition metals.

**Claims**

1. A process for depositing a coating of a selected transition metal nitride on a substrate, comprising the steps of:

A. placing a substrate within a deposition chamber;

B. selecting a transition metal nitride for deposition on said substrate;

C. providing a transition metal compound having the formula:

$$MR_x$$

wherein M is the selected transition metal; each R is selected from the group consisting of azide, halogen and:

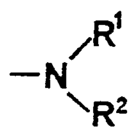

wherein $R^1$ and $R^2$ are selected from the group consisting of hydrogen, lower alkyl, cyclopentadienyl, and alkyl substituted cyclopentadienyl; at least one said R is not halogen; and x is an integer between 2 and 6 inclusive; and

D. introducing said transition metal compound into said deposition chamber while maintaining pyrolytic, nitride-forming conditions for said compound within said deposition chamber, thereby depositing said transition metal nitride on said substrate.

2. The process of claim 1, wherein said pyrolytic conditions include a temperature of from 400°C to 800°C and a partial pressure of said transition metal compound of from 0.2 torrs to 100 torrs.

3. The process of claim 1 or claim 2, wherein said introducing step is practiced by maintaining said transition metal compound in a liquid state, entraining said transition metal compound on a carrier gas, and transporting said entrained compound and carrier gas into said deposition chamber.

4. The process of claim 3, wherein said transition metal compound is entrained on said carrier gas in a bubbler.

5. The process of claim 3 or claim 4, wherein said carrier gas comprises a mixture of Hydrogen and Nitrogen.

6. The process of claim 3 o r caim 4, wherein said carrier gas comprises a mixture of Hydrogen and hydrazine.

7. The process of any preceding claim, wherein said substrate is Silicon or Gallium arsenide.

8. The process of any preceding claim, wherein the deposition rate of said transition metal nitride is at least 10 angstroms per minute.

9. The process of any preceding claim, wherein M is selected from the group consisting of: Titanium, Niobium, Zirconium, Hafnium, Tantalum, Molybdenum, Tungsten, Chromium and Vanadium.

10. The process of claim 9, wherein said compound MRx is selected from the group consisting of: tetrakis-dimethylaminotitanium, tetrakisdiethylaminotitanium, tetrakis-dimethylaminozirconium and tetrakisdiethylaminozirconium.

11. The process of claim 9, wherein said transition metal compound MRx is tetrakis(dimethylamino)titanium.